Europäisches Patentamt

European Patent Office

Office européen des brevets

(11) Publication number: **0 031 647**
**B1**

# (12) EUROPEAN PATENT SPECIFICATION

(45) Date of publication of patent specification: **26.02.86**

(51) Int. Cl.⁴: **G 11 C 19/08**

(21) Application number: **80304162.3**

(22) Date of filing: **20.11.80**

(54) Bubble memory structure.

(30) Priority: **10.12.79 US 102096**

(43) Date of publication of application:
**08.07.81 Bulletin 81/27**

(45) Publication of the grant of the patent:
**26.02.86 Bulletin 86/09**

(84) Designated Contracting States:
**DE FR GB**

(56) References cited:
**FR-A-2 384 322**
**US-A-3 931 618**
**US-A-4 091 362**

(73) Proprietor: **CONTROL DATA CORPORATION**
**8100-34th Avenue South**
**Minneapolis Minnesota 55440 (US)**

(72) Inventor: **Jallen, Gale Allen**
**1854 Alameda Street**
**Roseville Minnesota 55113 (US)**

(74) Representative: **Caro, William Egerton et al**
**J. MILLER & CO. Lincoln House 296-302 High Holborn**
**London WC1V 7JH (GB)**

Courier Press, Leamington Spa, England.

## Description

This invention relates to bubble memory structures.

French Specification No. 2384322 discloses a composite magnet for use in connection with bubble memory chips. This composite magnet comprises a square plate of a hard ferrite material and a plate of high permeability material. The plate of hard ferrite material has a non-constant cross-section so that the edge regions thereof are closer to a bubble memory chip than the central region so as to counteract fringe magnetic effects. The plate of high permeability material is a levelling plate to counteract self-demagnetising forces.

The present invention seeks to provide a bubble memory structure which has a permanent magnet of substantially constant thickness for ease of manufacture and which does not require a levelling plate, the permanent magnet being supported by a filler plate and shaped so that magnetic flux density is locally enhanced to compensate for self-demagnetising forces.

According to the present invention, there is provided a bubble memory structure including a magnetic field shielding means; a bubble memory chip within said shielding means; means for generating a rotating magnetic field in the vicinity of said bubble memory chip; and permanent magnet means so shaped as to produce a bias magnetic field which is substantially uniform over the entire bubble memory chip characterised in that said permanent magnet means comprises a permanent magnet of substantially constant thickness and contoured to be closer to said bubble memory chip at a central region than in regions disposed adjacent to the edges of the chip and a filler plate supporting the magnet from the shielding means so that magnetic flux density is locally enhanced to compensate for self-demagnetising forces and the bias magnetic field is substantially uniform at the bubble memory chip in the absence of a high permeability levelling plate.

The permanent magnet may be made of a ceramic material such as barium ferrite ceramic.

There may be two similarly shaped permanent magnets disposed on opposite sides of said bubble memory chip.

The invention is illustrated, merely by way of example, in the accompanying drawings, in which:—

Figure 1 is a cross-section of a known bubble memory structure; and

Figure 2 is a partial cross-sectional view of an embodiment of a bubble memory structure according to the present invention.

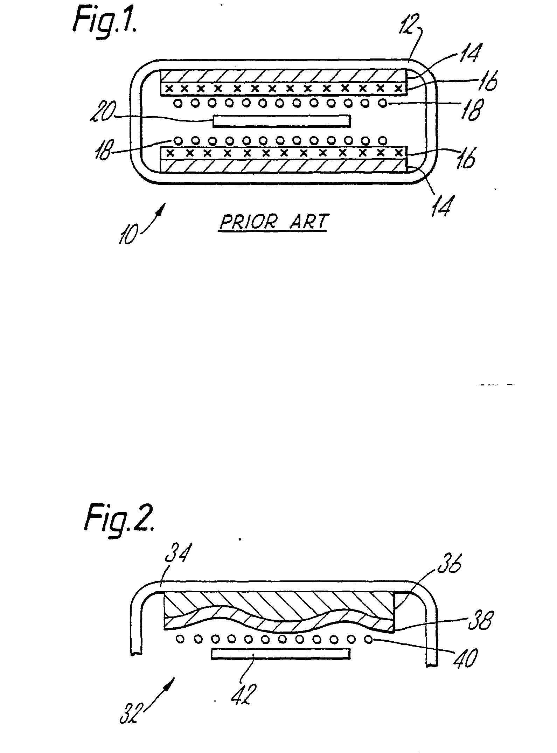

Referring now to Figure 1, a known bubble memory structure 10 has a shield 12. With the shield 12 are two permanent magnets 14. A levelling or smoothing plate 16 is disposed adjacent each magnet and adjacent each plate 16 there is a field coil 18. A bubble memory chip 20 (shown diagramatically) is provided in the centre of the bubble memory structure 10 between the field coils 18. The magnets 14 are planar. The plates 16 are of a high permeability material to help level the loss of flux density normally occurring in the central area of the magnets. These plates 16 are usually adjacent to the respective field coils 18. Since the field coils operate at a frequency of the order of 100 to 400 kHz, high eddy current and hysteresis losses can occur if the plates 16 are not formed of low loss materials such as linear ferrite.

The magnetic flux in the central area of the bubble memory structure of Figure 1 is reduced by so-called "self-demagnetizing forces". It is possible to offset the effects of the self-demagnetizing forces by increasing the magnetic forces in the central area of the plates 16. One way of increasing the magnetic force of a magnet is to increase its "length" which corresponds to an increase in its thickness. Generally, the amount of magnetic material comprising a magnet is increased to increase magnetic flux.

Figure 2 shows an embodiment of a bubble memory structure 32 according to the present invention. A shield 34 surrounds a field coil 40 and a bubble memory chip 42. A filler plate 36 is provided immediately internally of the shield 34 and is of an appropriate shape to support a magnet 38 which may be made of ceramic material such as a barium ferrite ceramic. The thickness of the magnet 38 is substantially constant. However, the effective thickness of the magnet 38 is varied. The required variation of the magnetic flux density at the bubble memory chip 42 to compensate for self-demagnetizing forces, is produced as a result of the spacing between the magnet and the chip. Thus, the plate 36 causes the magnet 38 to have a very small air gap in the central region where the magnet produces the weakest magnetic field. Thus the magnetic flux density is locally enhanced to compensate for self-demagnetizing forces and the bias magnetic field is substantially uniform at the bubble memory chip in the absence of a high permeability levelling plate. Although the air gap in Figure 2 is only represented diagramatically, the actual gap being much smaller than that represented, the principle is that the effect of the magnetic field is enhanced where the magnet itself is weakest by establishing a greater effective thickness by having a shorter effective magnetic flux path.

## Claims

1. A bubble memory structure including a magnetic field shielding means (34); a bubble memory chip (42) within said shielding means; means (40) for generating a rotating magnetic field in the vicinity of said bubble memory chip; and permanent magnet means (38) so shaped as to produce a bias magnetic field which is substantially uniform over the entire bubble memory chip characterised in that said permanent magnet means comprises a permanent magnet (38) of substantially constant thickness and contoured to be closer to said bubble memory chip at a central region than in regions disposed adjacent to the edges of the chip and a filler plate (36) supporting the magnet from the shielding means so that magnetic flux density is locally enhanced to compensate for self-demagnetizing forces and the bias magnetic field is substantially uniform at the bubble memory chip in the absence of a high permeability levelling plate.

2. A structure as claimed in claim 1 characterised in that the permanent magnet (38) is made of a ceramic material.

3. A structure as claimed in claim 2 characterised in that the permanent magnet (38) is made of a barium ferrite ceramic.

4. A structure as claimed in any preceding claim characterised in that there are two similarly shaped permanent magnets (38) disposed on opposite sides of said bubble memory chip.

## Revendications

1. Structure de mémoire à bulles comportant un blindage de champ magnétique (34) une pastille de mémoire à bulles (42) dans ledit blindage, un dispositif (40) destiné à produire un champ magnétique tournant dans le voisinage de ladite pastille de mémoire à bulles, et un aimant permanent (38) formé de manière à produire un champ magnétique de polarisation pratiquement uniforme sur toute la pastille de mémoire à bulles, caractérisée en ce que ledit aimant permanent comporte un aimant permanent (38) d'épaisseur pratiquement constante, mis en forme de manière à être plus proche de ladite pastille de mémoire à bulles dans une région centrale que dans des régions disposées près des bords de la pastille, et une plaque de remplissage (36) supportant l'aimant par rapport audit blindage de manière que la densité du flux magnétique soit améliorée localement pour compenser les forces d'autodémagnétisation, le champ magnétique de polarisation étant pratiquement uniforme sur la pastille de mémoire à bulles en l'absence d'une plaque de mise à niveau de haute perméabilité.

2. Structure selon la revendication 1, caractérisée en ce que l'aimant permanent (38) est fait d'une matière céramique.

3. Structure selon la revendication 2, caractérisée en ce que l'aimant permanent (38) est fait d'une céramique en ferrite de baryum.

4. Structure selon l'une quelconque des revendications précédentes, caractérisée en ce qu'elle comporte deux aimants permanents (38) de forme similaire disposé sur les faces opposées de ladite pastille de mémoire à bulles.

## Patentansprüche

1. Blasenspeicherstruktur mit einer Magnetfeld-Abschirmeinrichtung (34), mit einem Blasenspeicherchip (42) innerhalb der Abschirmeinrichtung, mit Einrichtungen (40) zur Erzeugung eines rotierenden Magnetfeldes in der Nähe des Blasenspeicherchips, und mit Permanentmagnetteilen (38), die so geformt sind, daß sie ein magnetisches Vorspannfeld erzeugen, das über den gesamten Blasenspeicherchip im wesentlichen gleichförmig ist, dadurch gekennzeichnet, daß die Permagnetteile einen eine im wesentlichen konstante Dicke aufweisenden Permanentmagneten (38) mit einer derartigen Kontur, daß er an einem Mittelbereich näher an dem Blasenspeicherchip liegt als in den benachbart zu den Kanten des Chips liegenden Bereichen, und eine Füllplatte (36) umfassen, die den Magneten derart an der Abschirmeinrichtung haltert, daß die Magnetflußdichte zur Kompensation von Selbstentmagnetisierungskräften örtlich vergrößert ist und daß das magnetische Vorspannfeld am Blasenspeicherchip bei Fehlen einer Ausgleichsplatte hoher Permeabilität im wesentlichen gleichförmig ist.

2. Struktur nach Anspruch 1, dadurch gekennzeichnet, daß der Permanentmagnet (38) aus einem Keramikmaterial besteht.

3. Struktur nach Anspruch 2, dadurch gekennzeichnet, daß der Permanentmagnet (38) aus einem Barium-Ferrit-Keramikmaterial hergestellt ist.

4. Struktur nach einem der vorhergehenden Ansprüche, dadurch gekennzeichnet, daß zwei in gleicher Weise geformte Permanentmagnete (38) auf gegenüberliegenden Seiten des Blasenspeicherchips angeordnet sind.

0 031 647

**Fig.1.**

PRIOR ART

**Fig.2.**

1